Europäisches Patentamt

European Patent Office

Office européen des brevets

(11) Publication number: **0 294 699 B1**

# EUROPEAN PATENT SPECIFICATION

(45) Date of publication of patent specification: **09.09.92**

(51) Int. Cl.⁵: **H01L 21/00**, H01L 21/28, H01L 21/82, H01L 29/92

(21) Application number: **88108774.6**

(22) Date of filing: **01.06.88**

(54) **Method for making capacitors in CMOS and NMOS processes.**

(30) Priority: **11.06.87 IT 2087987**

(43) Date of publication of application:
**14.12.88 Bulletin 88/50**

(45) Publication of the grant of the patent:
**09.09.92 Bulletin 92/37**

(84) Designated Contracting States:
**DE FR GB NL SE**

(56) References cited:
**US-A- 4 577 390**

(73) Proprietor: **SGS-THOMSON MICROELECTRON-ICS s.r.l.**
**Via C. Olivetti, 2**
**I-20041 Agrate Brianza Milano(IT)**

(72) Inventor: **Mazzali, Stefano**
**Via Crema 28**
**I-20135 Milan(IT)**

(74) Representative: **Modiano, Guido et al**
**MODIANO, JOSIF, PISANTY & STAUB**
**Modiano & Associati Via Meravigli, 16**
**I-20123 Milano(IT)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

EP 0 294 699 B1

## Description

The present invention relates to a method for making capacitors in CMOS and NMOS processes as defined in the claims.

As is known, Complementary Metal Oxide Silicon (CMOS) technology has been playing, for a few years, an important role in the integrated-circuit industry, by virtue of its substantially nil quiescent-state power consumption, as well as of its high switching speed, its compatibility with bipolar devices and its immunity to radiations. However, CMOS circuits are intrinsically less dense and more complicated than MOS integrated circuits which employ a single type of transistors. In fact, an NMOS structure typically requires, for its production, the deposition of seven layers using five masking steps, while a CMOS structure requires the deposition of twelve layers by means of ten masking steps.

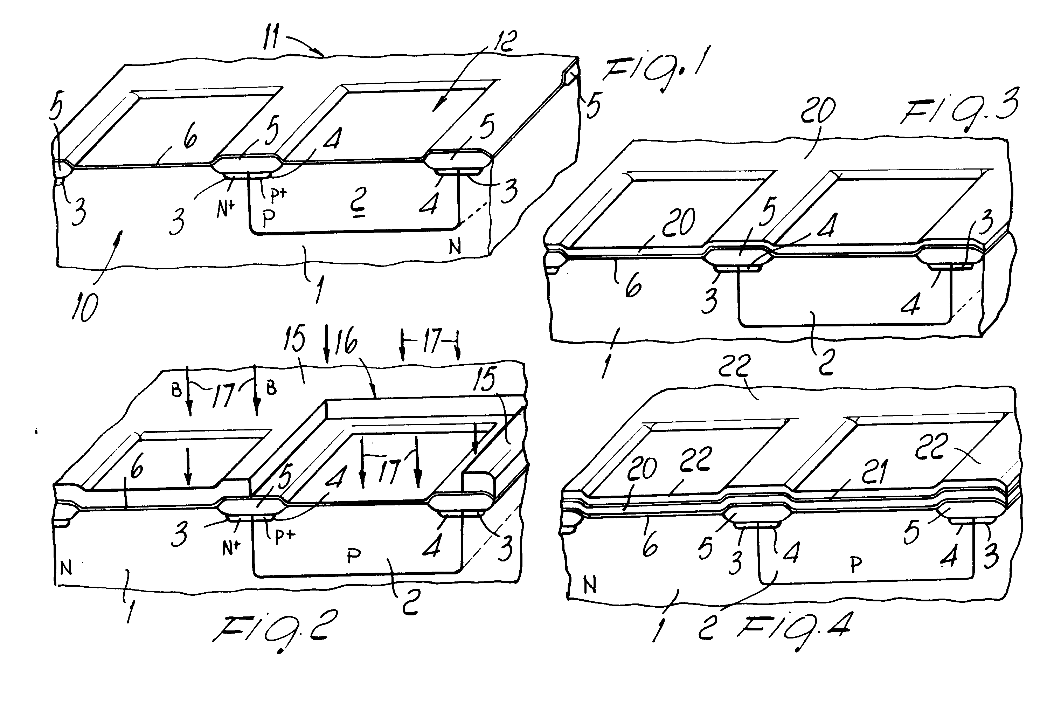

In particular, a currently used method for making CMOS devices including capacitors comprises forming, in a substrate with a first conductivity type, of a well of the opposite conductivity type by means of an appropriate masking step, definition (delimitation) of the active areas by means of an appropriate mask, implant and diffusion of appropriate ions for the definition of the insulation regions at junctions between regions with opposite conductivity type, field oxidation, for the obtainment of an intermediate structure, as shown for example in figure 1, comprising a substrate including an active region in which a transistor is to be provided and a region in which at least one capacitor is to be formed, and furthermore comprising a well with opposite conductivity in which the complementary transistor is to be produced. Subsequently, starting from this structure, a gate oxidation step, leading to the formation of an oxide layer, a masking step for the adjustment of the threshold, in which the region of the well remains uncovered for implanting boron ions, deposition of a first polysilicon layer, doping thereof by deposition of POCl$_3$, a masking step on the first polysilicon layer for the definition of the lower plate of the capacitor and of the gate regions of the complementary transistors are carried out. Then a structure similar to the intermediate one illustrated in figure 3 is obtained, showing the polysilicon portions constituting the gate of the complementary transistors and the lower plate of the capacitor. Subsequently the polysilicon is surface oxidated, a second polysilicon layer is deposited, the rear polysilicon is etched away, doping POCl$_3$ is further deposited, a further masking step covering only the region of the capacitor is carried out for the definition of the upper plate of said capacitor, with subsequent etching of the uncovered regions of the second polysilicon layer. Accordingly, a structure formed by the intermediate structure of figure 1 surmounted by the gate regions of the complementary transistors and by the capacitor formed by the two polysilicon layers, separated by an oxide layer is obtained. Then a further masking step is performed for the definition of the source-drain regions of the well, then the uncovered gate oxide is etched away, arsenic is implanted, the mask is removed and the surface is reoxidized. A further masking step is then performed for the definition of the source and drain regions of the transistor (S) in the substrate, with subsequent boron implant through the oxide covering the substrate. Then the masking layer is removed and the source and drain regions in the well and in the substrate are diffused. The process then continues with deposition of insulating layers of Vapox (Vapour deposited oxide) and BPSG (Boron Phosphorus Sylicon Glass), with reflow, then opening of the contacts, deposition of the metal layer, the metal mask (with etching), the deposition of final P-Vapox and the pad mask.

In US-A-4 577 390 a similar technique is employed to form capacitors in a CMOS structure. The dielectric layer is formed from a composite oxide/nitride film.

Accordingly, for making the capacitor and the CMOS transistors, five masks are necessary, and precisely a first mask for the adjustment of the threshold, a second mask for the definition of the lower plate of the capacitor and of the gate regions of the transistors, a third mask for the definition of the upper plate of the capacitor, a fourth mask for forming the source and drain regions in the well, and a fifth mask for forming the source and drain regions in the substrate. However, in view of the relatively high cost of each masking step, the need is felt to modify the known production process so as to reduce the number of production steps, in particular of masking steps and of used masks.

Accordingly, the aim of the present invention is to provide a method for making capacitors in CMOS and NMOS processes which entails reduction of the production steps and in particular of the masking steps required for the manufacture of said devices.

Within this aim, a particular object of the present invention is to provide a method which reduces the problems of registration of the successive masks used during this method.

Still another object of the present invention is to provide a method which comprises process steps which are already known per se and used in the manufacture of integrated devices, so as to allow the use of machines commonly used in the electronics industry.

Not least object of the present invention is to provide a method for making devices having electric characteristics comparable or actually improved with respect to those of devices produced according to known processes.

The indicated aim, the mentioned objects and others which will become apparent hereinafter are achieved by a method for making capacitors in CMOS and NMOS processes according to the invention, as indicated in the accompanying claims.

The characteristics and advantages of the invention will become apparent from the description of preferred but not exclusive embodiments, illustrated only by way of non-limitative example in the accompanying drawings, wherein:

figures 1 to 11 are sectional perspective views of a semiconductor wafer at different steps of a first embodiment of the method according to the invention; and

figures 12 to 16 are views, similar to the previous ones, to illustrate further making steps corresponding to those shown in figures 5 to 10 according to a different embodiment of the inventive method.

Reference should initially be made to figure 1, illustrating an intermediate structure including a substrate 1 with N-type conductivity with orientation [100] and 2.5-3 $\Omega$/cm resistivity, in which a P-well 2 is formed. In the structure of figure 1 the $N^+$-regions 3 (doped with phosphorus) and the $P^+$-regions 4 (doped with boron) have already been formed The portions of field oxide 5, surrounding the active region indicated at 10 in the substrate and the active region 12 in the well 2 and covering the region 11 on which one or more capacitors are to be formed are furthermore visible. The surface of the structure of figure 1 is covered by a gate oxide layer 6 having a thickness equal to 65 nm (650 Å).

Starting from the structure of figure 1, similarly to the prior art, a threshold adjustment mask is deposited, as illustrated in figure 2. As can be seen, the mask 15 covers the entire surface of the intermediate structure except the window 16 at the well 2. Then boron ions are implanted, as symbolized in figure 2 by the arrows 17, for the adjustment of the threshold. Then the resist layer constituting the mask 15 is removed and a first layer of polysilicon with thickness of 450 nm (4500 Å) is deposited, as indicated in figure 3 by the layer 20. Then, always in a known manner, doping POCl₃ is deposited so as to obtain a resistance V/I mono = 3-4 $\Omega$ .

Differently from the prior art, which comprised at this stage the deposition of a first mask for the definition of the lower plate of the capacitor and of the gate regions, according to the invention the surface of the polysilicon layer 20 is oxidized and a second polysilicon layer with thickness equal to 450 nm (4500 Å) is then deposited. The structure illustrated in figure 4 is thus obtained, with the oxide layer 21 being superimposed on the first polysilicon layer 20 and the second polysilicon layer 22 superimposed on the oxide layer 21. Then the polysilicon is etched away in the rearward regions in a known manner, and thereafter doping by means of POCl₃ is carried out to obtain resistance V/I mono = 3-4 $\Omega$ .

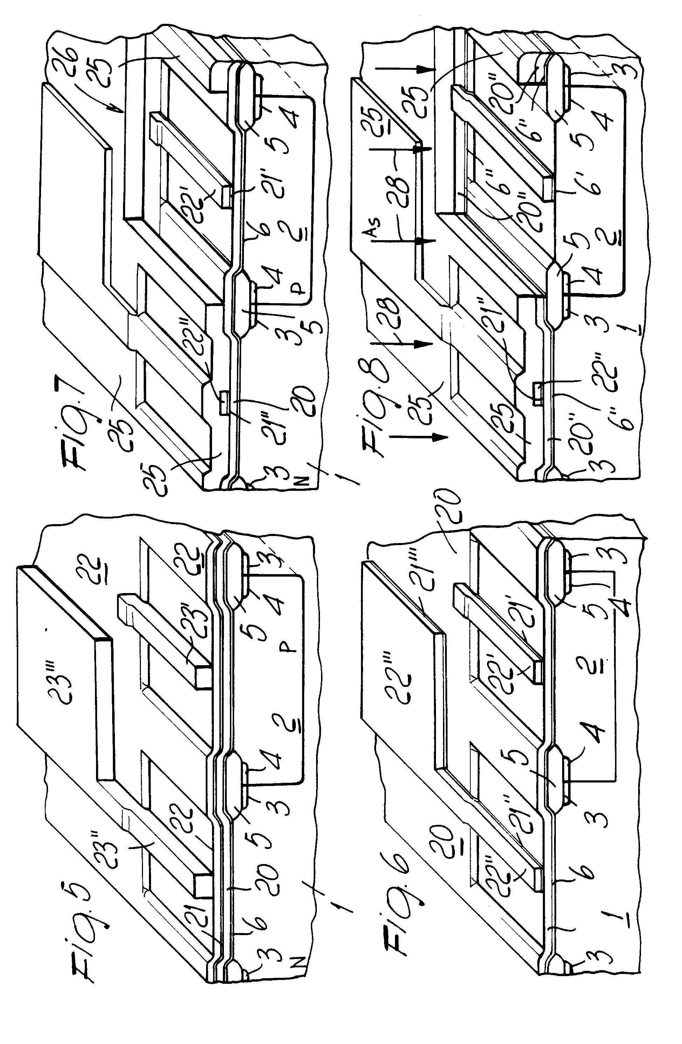

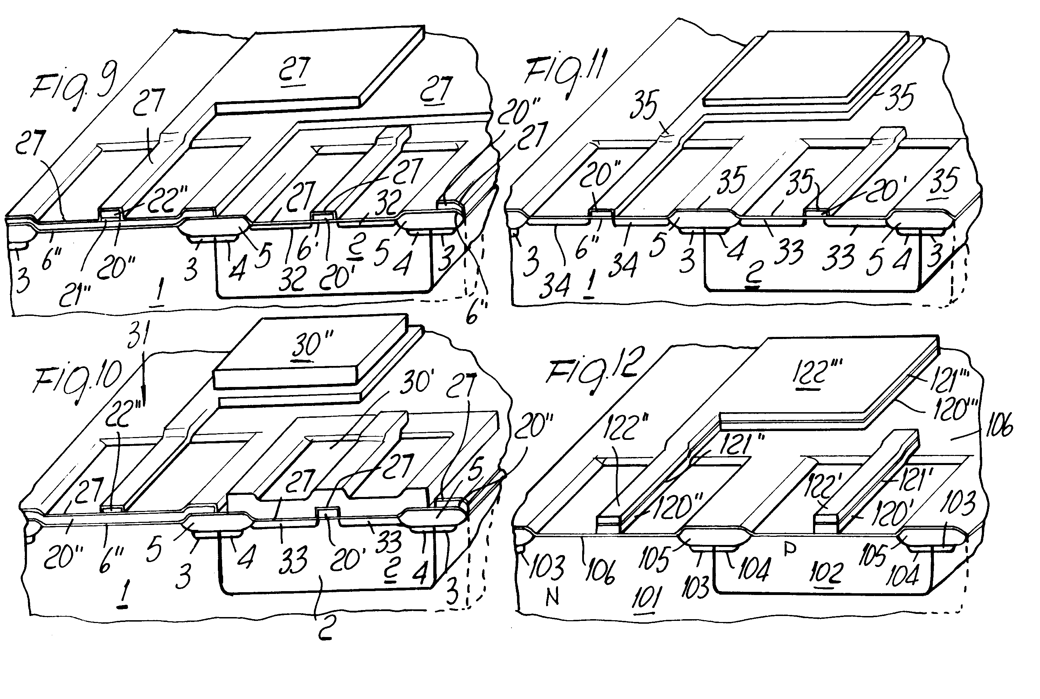

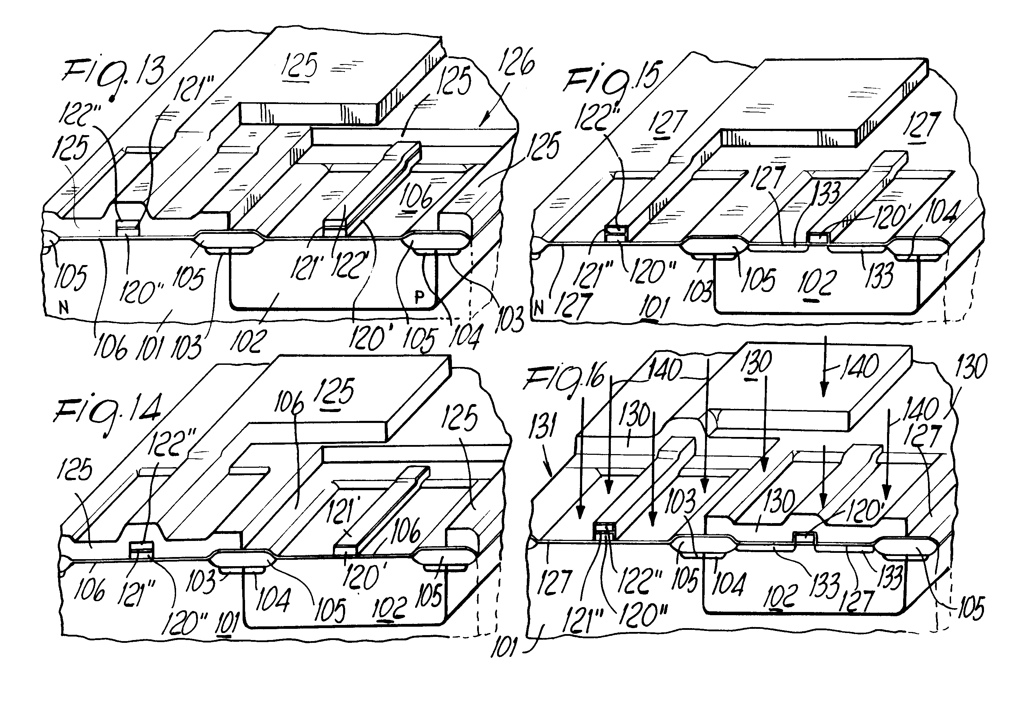

A masking step is then performed for the removal of portions of the second polysilicon layer. The mask shown in figure 5 is thus obtained, constituted by the resist portion 23′ covering the layer 22 at the region in which the gate of the N-channel transistor is to be formed inside the P-well, by the portion 23″, covering the layer 22 at the gate of the P-channel transistor to be formed in the substrate 1, and by the portion 23‴, connected to 23″, at the capacitor. Then the uncovered portions of the polysilicon layer 22 and the portions, consequently left uncovered, of the oxide layer 21 are etched away; subsequently the mask 23 is removed. Thus the structure illustrated in figure 6 is obtained, wherein above the first polysilicon layer 20 gate regions 21′ and 21″ and capacitor regions 21‴, remained from the oxide layer, and the corresponding portions 22′ 22″ and 22‴ of the second polysilicon layer are visible.

Then the mask 25 for the definition of the source and drain regions in the well 2 is deposited, as shown in figure 7. As can be seen, said mask, which is identical to the one for threshold adjustment shown in figure 2, has a window 26 at the well 2. Then the uncovered regions of the polysilicon 20 are etched away, with simultaneous removal also of the portion 22′, and then the uncovered gate oxide (layer 21′) is also etched away, with removal of the uncovered regions of the oxide 6. Thus the structure of figure 8 is obtained, wherein 6′ and 6″ indicate the remaining portions of the first oxide layer, and 20′ and 20″ indicate the remaining portions of the first polysilicon layer, respectively at the well 2 and at the further parts of the device. Then arsenic is implanted, as symbolised in figure 8 by the arrows 28.

Then the resist constituting the mask 25 is removed and the surface is reoxidized, with the obtainment of a layer 27 which covers the entire surface of the involved structure, as shown in figure 9. Then a further masking step is performed for the obtainment of the source-drain mask of the substrate, as shown in figure 10, wherein the portion 30′ of the mask covering the well region 2 and the portion 30″ which covers the region of the capacitor are visible. This mask has a window (indicated in the figure at 31) which leaves uncovered the surface of the structure at the active area of the substrate and at the field oxide region surrounding the capacitor. Then the uncovered portions of the oxide layer 27 and the portions, thus uncovered, of the first polysilicon layer 20″ are etched away, with simultaneous removal also of the remaining portion 22′ of the second polysilicon layer. Then boron is implanted through the oxide layer 6″ for the obtainment of the source and drain regions of the transistor formed in the substrate.

By removing the masking resist, and possibly by performing a further oxidation step, the structure of figure 11 is thus obtained, with an oxide layer 35 covering the entire face of the structure including the substrate 1, the well 2, the insulations 3 and 4, the field oxide regions 5, the source and drain regions 33, 34 and the polysilicon gate regions 20′ and 20″. Then the further known steps for forming the passivation layers and the metal layers follow.

As can be observed, in practice, according to the embodiment shown in the preceding figures, for making the capacitor and the complementary transistors only four masks are sufficient, and precisely the mask 15 (figure 2) for threshold adjustment, the mask 23′-23″ (figure 5) for the definition of the upper plate of the capacitor and of the regions, in the upper polysilicon layer 22, overlying the portions of the first polysilicon layer 20 in which the gate regions are to be formed, the mask (figures 7 and 8) for source and drain regions in the well 2, and the mask 30′-30″ (figure 10) for source and drain regions in the substrate 1 and the definition of the lower plate of the capacitor. Essentially, the mask for the source and drain regions in the substrate is employed for the definition of the second plate of the capacitor, thus eliminating the specific masking step provided for this purpose according to the prior art.

Figures 12 to 16 are successive views of a semiconductor structure during different capacitor production steps, according to another embodiment of the method shown with reference to figures 1 to 11. More in particular, this embodiment comprises process steps identical to those shown for the previous example up to obtain the structure of figure 5, which comprises the two polysilicon layers, interleaved by an oxide layer, deposited above the substrate and the mask 23′-23″ at the regions in which the capacitor and the gate regions are to be formed. According to this embodiment, after etching the upper polysilicon layer and the interposed oxide, the lower polysilicon layer is etched using the same mask. The structure of figure 12 is thus obtained, wherein the elements corresponding to the previously shown embodiment have been indicated by the same reference numerals increased by 100. In the figure, the N-type substrate 101, the P-well 102, the insulations 103 and 104, the field oxide regions 105, the oxide layer 106, the first polysilicon portions 120′, 120″ and 120‴ respectively defining the gate of the transistor to be formed in the well 102, the gate of the transistor to be formed in the substrate 101 and the lower plate of the capacitor, the oxide portions 121′, 121″ and 121‴ and the second polysilicon layer portions 122′, 122″ and 122‴, arranged exactly overlying the remaining portions of the first polysilicon layer are visible. Then a masking step is performed for the obtainment of the mask 125 shown in figure 13. Said mask, identical to the threshold adjustment mask 15, has a window 126 at the well 102, as shown in figure 13. Then the uncovered second polysilicon layer portion 122′, is etched away, obtaining the structure visible in figure 14. The oxide 121′ is then etched, arsenic is implanted to form the source and drain regions of the transistor in the well 102, the masking resist layer 125 is removed and the surface is reoxidized, obtaining the structure shown in figure 15, in which the layers 133 accommodating the implanted arsenic ions, and the oxide layer 127 which covers the entire surface are visible.

Then the mask for the source and drain regions in the substrate, made of the resist layer 130 shown in figure 16, is deposited. Said mask, having a window 131 at the active region of the substrate, thus allows a successive implant of boron ions through the oxide layer 127. Subsequently, if desired, the uncovered oxide 127 and the polysilicon are etched, removing the portion 122″. Then the mask 130 is removed and, if necessary, a further reoxidation of the surface is performed.

As can be seen from figures 12 to 16, according to this different embodiment the mask defining the upper plate of the capacitor and adapted to define the gate regions of the complementary transistors (by virtue of the selectivity of the oxide and polysilicon etchings) has been used for the definition of the lower plate of the capacitor. In this case, too, the method therefore requires one masking step less than the prior art.

The method allows numerous other variations, not illustrated in detail. In particular the fact is stressed that though in the first embodiment the mask for the source and drain regions in the substrate has been used for the definition of the lower plate of the capacitor, and though, in the second embodiment, the mask defining the upper plate of the capacitor is used for the same purpose, an embodiment is conceivable in which the mask used to form the source and drain regions in the well is employed for the definition of the lower plate of the capacitor by appropriately configuring the employed masks.

Furthermore the steps for obtaining the source and drain regions within the well and within the substrate may be performed in the inverse sequence, this possibly being even advantageous in order to save oxide etching and reoxidation steps, by virtue of the possibility of implanting the boron ions through an oxide layer.

It is furthermore possible to produce capacitors by directly employing the polysilicon lines defining the gate regions of the complementary transistors. In this case the obtained capacitors do not have the square shape illustrated in the figures, but are manufactured by making use of the considerable length of the polysilicon lines above the field oxide regions. In this manner a considerable saving of space and therefore an increase in the density of the device are obtained, which advantage is particularly appreciated in view of the current trend towards miniaturization.

As is apparent from the preceding description, the invention fully achieves the intended aim and objects. In particular, by employing one of said masks, it is possible to reduce the number of masking steps, thus reducing the costs of the finished device.

The fact should furthermore be stressed that the method according to the invention allows the elimination of the registration errors of the mask of the second polysilicon layer used to produce the upper plate of the capacitors, which risk is present in the method according to the prior art.

The invention thus conceived is susceptible to numerous modifications and variations. In particular, besides the possibilities already illustrated above, the fact is stressed that the reoxidation steps may be replaced with the deposition of oxides such as TEOS (Tetraethylorthosilicate) or ONO (Oxide-Nitride-Oxide).

The method according to the invention, typically illustrated for a CMOS process with P-well, may furthermore also be applied to CMOS processes in a P-type substrate with N-well by appropriately modifying the sequence of the steps and the implanted ion species, or even to NMOS processes of the type with double polysilicon layer in which the second polysilicon layer is used only for the capacitor plates, by employing again either the mask which defines the upper plate of the capacitor or the mask for patterning the gate regions in order to pattern the lower capacitor plate.

The fact is furthermore stressed that the thicknesses and the dopings of the polysilicon layers indicated in the preceding description are merely by way of example.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

**Claims**

1. A method for making capacitors in CMOS processes, comprising :
   - a first step of depositing a first semiconductor layer (20,120) on a semiconductor substrate (1,101) having a first conductivity type, having at least one active region (10) wherein a first MOS transistor is to be formed, said substrate (1,101) accommodating at least one well (2,102) of a second conductivity type, wherein a second MOS transistor is to be formed, and said substrate (1,101) being partially covered by field oxide and gate oxide layers (5,6,105),
   - a second step of growing an insulating layer (21,121) on said first semiconductor layer,
   - a third step of depositing a second semiconductor layer (22,122) on said insulating layer (21,121),
   - the steps of masking said second semiconductor layer with a first mask (23) covering portions defining a second plate of said capacitors (122"') and gate regions of said first and second transistors,
   - removing portions of said second semiconductor layer not covered by said first mask,
   - masking said semiconductor layers with a second mask (25,125) having at least one first window (26,126) above said well,
   - carrying out a first implantation of ions through said first window to form source and drain regions of said first conductivity type,
   - masking said semiconductor layers with a third mask (30,130) having at least one second window (31,131) above said active region of said substrate,
   - carrying out a second ion implantation through said second window to form source and drain regions of said second conductivity type,
   - using at least one of said first, second and third masks for removing delimitation portions of said first semiconductor layer (20) extending beyond the region covered by said second capacitor plate, thereby defining said first capacitor plate (120"').

2. A method according to claim 1, characterized in that said third mask (30) is used for removing said delimitation portions.

**3.** A method according to claims 1 and 2, characterized, after said steps of deposition of said first semiconductor layer (20), growth of said insulating layer, deposition of said second semiconductor layer (22), first masking (23) of said second layer, removal of portions of said second layer, by the steps of: applying said second mask (25), removing portions of said first layer above said well (2), carrying out said first ion implantation (28), applying said third mask (30) having windows (31) above said active region (10) of said substrate (1) and said delimitation portions of said first layer, removing portions of said first layer exposed by said windows, and carrying out said second ion implantation.

**4.** A method according to claim 1, characterized in that said second mask is used for removing said delimitation portions of said first semiconductor layer.

**5.** A method according to claims 1 and 4, characterized, after said steps of deposition of said first semiconductor layer, growth, deposition of said second semiconductor layer, first masking of said second layer, removal of portions of said second layer, by the steps of: applying said second mask having windows above said well and said delimitation portions of said first layer, removing portions of said first semiconductor layer exposed by said windows, carrying out said first ion implantation, applying said third mask, removing exposed portions of said first semiconductor layer above said active region, and carrying out said second ion implantation.

**6.** A method according to claim 3 or 5, characterized in that a step of removal of exposed portions of said insulating layer (21) is carried out immediately after said step of removal of portions of said second layer (22).

**7.** A method according to claim 3 or 5, characterized in that a step of removal of exposed portions of said insulating layer (21) is carried out immediately after applying said second mask.

**8.** A method according to claim 3 or 5, characterized in that application of said second mask (25), said first removal of portions of said first semiconductor layer (20) and said first implantation (28) are carried out before said steps of applying said third mask (30), second removal of portions of said first semiconductor layer and second implantation.

**9.** A method according to claim 3 or 5, characterized in that said application of said third mask, said second removal of exposed portions of said first semiconductor layer and said second implantation are carried out before said steps of applying said second mask, first removal of exposed portions of said first semiconductor layer and said first implantation.

**10.** A method according to claim 1, characterized in that said first mask (23) is used for removing said delimitation portions of said first semiconductor layer.

**11.** A method according to claims 1 and 10, characterized, after said steps of deposition of said first semiconductor layer (20), growth of said insulating layer (21), deposition of said second semiconductor layer (22), application of said first mask (23) to said second layer, removal of exposed portions of said second layer (22), by the steps of: removal of exposed portions of said insulating layer (21), removal of exposed portions of said first semiconductor layer (20), application of said second mask (125), said first ion implantation, application of said third mask (130) and said second ion implantation (140).

**12.** A method according to claim 11, characterized in that said steps of applying said second mask (125) and of first ion implantation are carried out before said steps of applying said third mask (130) and of second ion implantation (140).

**13.** A method according to claims 11 and 12, characterized, after application of said second mask, by the steps of removal of exposed portions (122′) of said second layer, removal of exposed portions of said insulating layer (121′) and any exposed portions of said insulating layer (106) covering said well (102) prior to said first ion implantation.

**14.** A method according to claim 11, characterized in that said steps of applying said third mask and of second ion implantation are carried out before said steps of applying said second mask and of first ion implantation.

**15.** A method for making capacitors in NMOS processes, comprising the steps of:
- a first step of depositing a first semiconductor layer on a semiconductor substrate having active regions wherein NMOS transistors are to be formed and being partially covered by field oxide and gate oxide layers,

- a second step of growing an insulating layer on said first semiconductor layer,
- a third step of depositing a second semiconductor layer,
- the steps of masking said semiconductor layer with a first mask covering portions defining a second plate of said capacitors and gate regions of said transistors,
- removing portions of said second semiconductor layer not covered by said first mask,
- masking said first semiconductor layer with a second mask having at least one window above said active region,
- implanting ions through said window to form source and drain regions in said active region,
- using at least one of said first and second masks for removing delimitation portions of said first semiconductor layer extending beyond the region covered by said first capacitor plate, thereby defining the first capacitor plate.

**Patentansprüche**

1.  Verfahren zur Herstellung von Kondensatoren in CMOS-Verfahren, mit
    - einem ersten Schritt, eine erste Halbleiterschicht (20, 120) auf einem Halbleitersubstrat (1, 101) mit einer ersten Leitfähigkeitsart aufzubringen, welches mindestens einen aktiven Bereich (10) besitzt, in der ein erster MOS-Transistor auszubilden ist, wobei das Substrat (1, 101) mindestens eine Mulde (2, 102) einer zweiter Leitfähigkeitsart enthält, in der ein zweiter MOS-Transistor auszubilden ist, und das Substrat (1, 101) teilweise von Feldoxid- und Gateoxidschichten (5, 6, 105) bedeckt wird,
    - einem zweiten Schritt, eine Isolierschicht (21, 121) auf der ersten Halbleiterschicht aufzuwachsen,
    - einem dritten Schritt, eine zweite Halbleiterschicht (22, 122) auf der Isolierschicht (21, 121) aufzubringen,
    - den Schritten, die zweite Halbleiterschicht mit einer ersten Maske (23) zu maskieren, die Bereiche abdeckt, die eine zweite Platte der Kondensatoren (122''') und Gatebereiche der ersten und zweiten Transistoren bilden,
    - nicht von der ersten Maske bedeckte Abschnitte der zweiten Halbleiterschicht zu beseitigen,
    - die Halbleiterschichten mit einer zweiten Maske (25, 125) mit mindestens einem ersten Fenster (26, 126) über der Mulde zu maskieren,
    - eine erste Implantation von Ionen durch das erste Fenster durchzuführen, um Source- und Drain-Bereiche der ersten Leitfähigkeitsart auszubilden,
    - die Halbleiterschichten mit einer dritten Maske (30, 130) mit mindestens einem zweiten Fenster (31, 131) über dem aktiven Bereich des Substrates zu maskieren,
    - eine zweite Ionen-Implantation durch das zweite Fenster durchzuführen, um Source- und Drain-Bereiche der zweiten Leitfähigkeitsart auszubilden,
    - mindestens eine der ersten, zweiten und dritten Masken zur Beseitigung von Grenzbereichen der ersten Halbleiterschicht (20) zu verwenden, welche sich über den von der zweiten Kondensatorplatte bedeckten Bereich erstrecken, wodurch die erste Kondensatorplatte (120''') gebildet wird.

2.  Verfahren nach Anspruch 1, dadurch gekennzeichnet, daß die dritte Maske (30) zur Beseitigung der Grenzbereiche verwendet wird.

3.  Verfahren nach einem der Ansprüche 1 und 2, gekennzeichnet nach den Schritten der Aufbringung der ersten Halbleiterschicht (20), des Aufwachsens der Isolierschicht, des Aufbringens der zweiten Halbleiterschicht (22), der ersten Maskierung (23) der zweiten Schicht, der Beseitigung der Bereiche der zweiten Schicht durch die Schritte, die zweite Maske (25) aufzubringen, Bereiche der ersten Schicht über der Mulde (2) zu beseitigen, die erste Ionen-Implantation (28) durchzuführen, die dritte Maske (30) mit Fenstern (21) über dem aktiven Bereich (10) des Substrates (1) und den Grenzbereichen der ersten Schicht aufzulegen, von den Fenstern freigelegte Bereiche der ersten Schicht zu beseitigen und die zweite Ionen-Implantation durchzuführen.

4.  Verfahren nach Anspruch 1, dadurch gekennzeichnet, daß die zweite Maske zur Beseitigung der Grenzbereiche der ersten Halbleiterschicht verwendet wird.

5.  Verfahren nach den Ansprüchen 1 und 4, gekennzeichnet nach den Schritten des Aufbringens der ersten Halbleiterschicht, des Aufwachsens, des Aufbringens der zweiten Halbleiterschicht, der ersten Maskierung der zweiten Schicht, der Beseitigung von Bereichen der zweiten Schicht durch die Schritte, die zweite Maske mit Fenstern über der Mulde und den Grenzbereichen der ersten Schicht aufzubringen, von den Fenstern freigelegte Bereiche der ersten Halbleiterschicht zu beseitigen, die erste Ionen-Implantation durchzuführen, die dritte Maske aufzulegen, freigelegte Bereiche der ersten Halbleiterschicht über dem aktiven Bereich zu beseitigen und die zweite Ionen-Implantation durchzuführen.

6. Verfahren nach Anspruch 3 oder 5,
dadurch gekennzeichnet, daß ein Schritt zur Beseitigung der freigelegten Bereiche der Isolierschicht (21) sofort nach dem Schritt zur Beseitigung der Bereiche der zweiten Schicht (22) durchgeführt wird.

7. Verfahren nach Anspruch 3 oder 5,
dadurch gekennzeichnet, daß ein Schritt zur Beseitigung von freigelegten Bereichen der Isolierschicht (21) sofort nach Auflegen der zweiten Maske durchgeführt wird.

8. Verfahren nach Anspruch 3 oder 5,
dadurch gekennzeichnet, daß das Auflegen der zweiten Maske (25), die erste Beseitigung von Bereichen der ersten Halbleiterschicht (20) und die erste Implantation (28) vor den Schritten des Auflegens der dritten Maske (30), der zweiten Beseitigung von Bereichen der ersten Halbleiterschicht und der zweiten Implantation durchgeführt werden.

9. Verfahren nach Anspruch 3 oder 5,
dadurch gekennzeichnet, daß das Auflegen der dritten Maske, die zweite Beseitigung von freigelegten Bereichen der ersten Halbleiterschicht und die zweite Implantation vor den Schritten des Auflegens der zweiten Maske, der ersten Beseitigung der freigelegten der ersten Halbleiterschicht und der ersten Implantation durchgeführt werden.

10. Verfahren nach Anspruch 1,
dadurch gekennzeichnet, daß die erste Maske (23) zur Beseitigung der Grenzabschnitte der ersten Halbleiterschicht verwendet wird.

11. Verfahren nach den Ansprüchen 1 und 10,
gekennzeichnet nach den Schritten des Aufbringens der ersten Halbleiterschicht (20), des Aufwachsens der Isolierschicht (21), des Aufbringens der zweiten Halbleiterschicht (22), des Auflegens der ersten Maske (23) auf die zweite Schicht, der Beseitigung der freigelegten Bereiche der zweiten Schicht (22) durch die Schritte: Beseitigung der freigelegten Bereiche der Isolierschicht (21), Beseitigung der freigelegten Bereiche der ersten Halbleiterschicht (20), Anlegen der zweiten Maske (25), die erste Ionen-Implantation, Anlegen der dritten Maske (130) und die zweite Ionen-Implantation (140).

12. Vefahren nach Anspruch 11,
dadurch gekennzeichnet, daß die Schritte des Anlegens der zweiten Maske (125) und der ersten Ionen-Implantation vor den Schritten des Anlegens der dritten Maske (130) und der zweiten Ionen-Implantation (140) durchgeführt werden.

13. Verfahren nach den Ansprüchen 11 und 12,
gekennzeichnet nach Anlegen der zweiten Maske durch die Schritte: Beseitigung der freigelegten Bereiche (122') der zweiten Schicht, Beseitigung der freigelegten Bereiche der Isolierschicht (121') und von freigelegten Abschnitten der die Mulde (102) bedeckenden Isolierschicht (106) vor der ersten Ionen-Implantation.

14. Verfahren nach Anspruch 11,
dadurch gekennzeichnet, daß die Schritte des Anlegens der dritten Maske und der zweiten Ionen-Implantation vor den Schritten des Anlegens der zweiten Maske und der ersten Ionen-Implantation durchgeführt werden.

15. Verfahren zur Herstellung von Kondensatoren in NMOS-Verfahren, mit den Schritten:
   - einem ersten Schritt, eine erste Halbleiterschicht auf einem Halbleitersubstrat mit aktiven Bereichen aufzubringen, in denen NMOS-Transistoren auszubilden sind und teilweise von Feldoxid- und Gateoxidschichten bedeckt werden,
   - einem zweiten Schritt, eine Isolierschicht auf die erste Halbleiterschicht aufzuwachsen,
   - einem dritten Schritt, eine zweite Halbleiterschicht aufzubringen,
   - die Schritte, die Halbleiterschicht mit einer ersten Maske zu maskieren, die Bereiche abdeckt, welche eine zweite Platte des Kondensators und Gate-Bereiche des Transistors bilden,
   - nicht von der ersten Maske bedeckte Bereiche der zweiten Halbleiterschicht zu beseitigen,
   - die erste Halbleiterschicht mit einer zweiten Maske mit mindestens einem Fenster über dem aktiven Bereich zu maskieren,
   - Ionen durch das Fenster zu implantieren, um Source- und Drain-Bereiche im aktiven Bereich auszubilden,

- mindestens eine der ersten und zweiten Masken zur Beseitigung von Grenzabschnitten der ersten Halbleiterschicht zu verwenden, welche sich über den von der ersten Kondensatorplatte überdeckten Bereich erstrecken, wodurch die erste Kondensatorplatte gebildet wird.

**Revendications**

1. Procédé de fabrication de condensateurs en technologie CMOS comprenant :

une première étape de dépôt d'une première couche semiconductrice (20, 120) sur un substrat semiconducteur (1, 101) ayant un premier type de conductivité, comprenant au moins une région active (10) dans laquelle un premier transistor MOS doit être formé, ce substrat (1, 101) comprenant au moins un caisson (2, 102) d'un second type de conductivité dans lequel un second transistor MOS doit être formé, et le substrat (1, 101) étant partiellement recouvert de couches d'oxyde de champ et d'oxyde de grille (5, 6, 105),

une deuxième étape de croissance d'une couche isolante (21, 121) sur la première couche semiconductrice,

une troisième étape de dépôt d'une seconde couche semiconductrice (22, 122) sur la couche isolante (21, 121), et les étapes suivantes :

- masquer la seconde couche semiconductrice par un premier masque (23) recouvrant des parties définissant une seconde plaque du condensateur (122''') et les régions de grille des premier et second transistors,
- enlever des parties de la seconde couche semiconductrice non-recouvertes par le premier masque,
- masquer les couches semiconductrices par un deuxième masque (25, 125) ayant au moins une première fenêtre (26, 126) au-dessus dudit caisson,
- effectuer une première implantation ionique à travers la première fenêtre pour former des régions de source et de drain du premier type de conductivité,
- masquer les couches semiconductrices par un troisième masque (30, 130) comprenant au moins une seconde fenêtre (31, 131) au-dessus de la région active du substrat,
- effectuer une seconde implantation ionique à travers la seconde fenêtre pour former des régions de source et de drain du second type de conductivité,

- utiliser au moins l'un des premier, deuxième et troisième masques pour enlever des parties de délimitation de la première couche semiconductrice (20) s'étendant au-delà de la région couverte par la seconde plaque du condensateur, définissant ainsi la première plaque de condensateur (120''').

2. Procédé selon la revendication 1, caractérisé en ce que le troisième masque (30) est utilisé pour enlever les parties de délimitation.

3. Procédé selon les revendications 1 et 2, caractérisé, après les étapes de dépôt de la première couche semiconductrice (20), de croissance de la couche isolante, de dépôt de la seconde couche semiconductrice (22), de premier masquage (23) de la seconde couche, d'enlèvement de parties de la seconde couche, par les étapes suivantes : appliquer le second masque (25), enlever des parties de la première couche au-dessus du caisson (2), effectuer la première implantation ionique (28), appliquer le troisième masque (30) muni de fenêtres (31) au-dessus de la région active (10) du substrat (1) et des parties de délimitation de la première couche, enlever des parties de la première couche exposées par lesdites fenêtres, et effectuer la seconde implantation ionique.

4. Procédé selon la revendication 1, caractérisé en ce que le deuxième masque est utilisé pour enlever les parties de délimitation de la première couche semiconductrice.

5. Procédé selon les revendications 1 et 4, caractérisé, après les étapes de dépôt de la première couche semiconductrice, de croissance, de dépôt de la seconde couche semiconductrice, de premier masquage de la seconde couche, d'enlèvement de la deuxième couche, par les étapes suivantes : appliquer le deuxième masque muni de fenêtres au-dessus du caisson et des parties de délimitation de la première couche, enlever des parties de la première couche semiconductrice exposées par les fenêtres, effectuer la première implantation ionique, appliquer le troisième masque, enlever des parties exposées de la première couche semiconductrice au-dessus des régions actives, et effectuer la seconde implantation ionique.

6. Procédé selon la revendication 3 ou 5, caractérisé en ce qu'une étape d'enlèvement des parties exposées de la couche isolante (21) est mise en oeuvre immédiatement après l'étape d'enlèvement de parties de la seconde couche (22).

7. Procédé selon la revendication 3 ou 5, caractérisé en ce qu'une étape d'enlèvement des parties exposées de la couche isolante (21) est effectuée immédiatement après l'application du deuxième masque.

8. Procédé selon la revendication 3 ou 5, caractérisé en ce que l'application du deuxième masque (25), le premier enlèvement de parties de la première couche semiconductrice (20) et la première implantation (28) sont effectués avant l'étape consistant à appliquer le troisième masque (30), le second enlèvement de parties de la première couche semiconductrice et la seconde implantation.

9. Procédé selon la revendication 3 ou 5, caractérisé en ce que l'application du troisième masque, le second enlèvement de parties exposées de la première couche semiconductrice et la seconde implantation sont effectués avant les étapes d'application du deuxième masque, de premier enlèvement de parties exposées de la première couche semiconductrice et de première implantation.

10. Procédé selon la revendication 1, caractérisé en ce que le premier masque (23) est utilisé pour enlever des parties de délimitation de la première couche semiconductrice.

11. Procédé selon les revendications 1 et 10, caractérisé, après les étapes de dépôt de la première couche semiconductrice (20), de croissance de la couche isolante (21), de dépôt de la seconde couche semiconductrice (22), d'application du premier masque (23) sur la seconde couche, d'enlèvement des parties exposées de la deuxième couche (22), par les étapes suivantes : enlèvement des parties exposées de la couche isolante (21), enlèvement des parties exposées de la première couche semiconductrice (20), application du deuxième masque (25), première implantation ionique, application du troisième masque (130) et deuxième implantation ionique (140).

12. Procédé selon la revendication 11, caractérisé en ce que les étapes d'application du deuxième masque (125) et de première implantation ionique sont effectuées avant les étapes d'application du troisième masque (130) et de seconde implantation ionique (140).

13. Procédé selon les revendications 11 et 12, caractérisé, après application du deuxième masque, par les étapes d'enlèvement des parties exposées (122') de la seconde couche, d'enlèvement des parties exposées de la couche isolante (121') et de toute partie exposée de la couche isolante (106) recouvrant le caisson (102) avant la première implantation ionique.

14. Procédé selon la revendication 11, caractérisé en ce que les étapes d'application du troisième masque et de seconde implantation ionique sont effectuées avant les étapes d'application du deuxième masque et de première implantation ionique.

15. Procédé de fabrication de condensateurs en technologie NMOS comprenant les étapes suivantes :
   - une première étape de dépôt d'une première couche semiconductrice sur un substrat semiconducteur ayant des régions actives dans lesquelles les transistors NMOS doivent être formés et partiellement recouvert de couches d'oxyde de champ et d'oxyde de grille,
   - une deuxième étape de croissance d'une couche isolante sur la première couche semiconductrice,
   - une troisième étape de dépôt d'une seconde couche semiconductrice,
   et les étapes suivantes :
   - masquer la couche semiconductrice par un premier masque recouvrant des parties définissant une seconde plaque des condensateurs et des régions de grille des transistors.
   - enlever des parties de la seconde couche semiconductrice non-recouvertes du premier masque,
   - masquer la première couche semiconductrice par un deuxième masque muni d'au moins une fenêtre au-dessus de la région active,
   - implanter des ions à travers la fenêtre pour former des régions de source et de drain dans la région active,
   - utiliser au moins l'un des premier et deuxième masques pour enlever des parties de délimitation de la première couche semiconductrice s'étendant au-delà de la région recouverte par la première plaque du condensateur, définissant ainsi la première plaque du condensateur.

Fig.1

Fig.2

Fig.3

Fig.4

EP 0 294 699 B1

Fig. 5

Fig. 6

Fig. 7

Fig. 8

EP 0 294 699 B1

Fig. 9

27 27 27 27 27 27 27 27 27

22" 32 32 20"

3 6" 20" 3 4 5 6' 2 5 4 3 6"

21" 1 32 20'

Fig. 10

31 30" 30' 27

22" 27

27 20"

27 27

5

20" 6" 5 3 4 33 20' 33 2 4

1 3 3

2

Fig. 11

35 35

20" 35 35 20' 35

21 20"

3 6" 34 5 3 4 33 33 5 4 3

34 1 2

Fig. 12

122"' 121"'

120"'

122" 121" 106

121"

122' 121'

120" 120' 103

103 106 105 103 104 P 102 105 104

N 101 103

EP 0 294 699 B1

Fig.13

Fig.15

Fig.14

Fig.16

EP 0 294 699 B1